Europäisches Patentamt

European Patent Office

Office européen des brevets

(19)

(11) Veröffentlichungsnummer: **0 166 912**
**B1**

(12) **EUROPÄISCHE PATENTSCHRIFT**

(45) Veröffentlichungstag der Patentschrift: 29.08.90

(51) Int. Cl.⁵: **G 01 R 31/28**

(21) Anmeldenummer: **85105524.4**

(22) Anmeldetag: **06.05.85**

(54) **Verfahren zur elektrischen Prüfung von Mikroverdrahtungen mit Hilfe von Korpuskularsonden.**

(30) Priorität: **01.06.84 DE 3420552**

(43) Veröffentlichungstag der Anmeldung:
**08.01.86 Patentblatt 86/02**

(45) Bekanntmachung des Hinweises auf die
Patenterteilung:
**29.08.90 Patentblatt 90/35**

(84) Benannte Vertragsstaaten:
**DE FR GB NL**

(73) Patentinhaber: **Siemens Aktiengesellschaft**
**Wittelsbacherplatz 2**
**D-8000 München 2 (DE)**

(72) Erfinder: **Lischke, Burkhard, Prof. Dr.**
**In der Huluss 13**
**D-8000 München 82 (DE)**

(56) Entgegenhaltungen:
**EP-A-0 066 070**
**EP-A-0 104 577**

**IBM TECHNICAL DISCLOSURE BULLETIN, Band
9, Nr. 12, Mai 1967, Seite 1734, New York, US;
D.N. NEPELA: "Electron beam readout of data"**

**EXTENDED ABSTRACTS, Band 82-1, Mai 1982,
Seiten 491-492, Pennington, New Yersey, US;
S.D. GOLLADAY et al.: "Contactless electrical
testing of semiconductor packaging modules
with multiple electron beams"**

Courier Press, Leamington Spa, England.

EP 0 166 912 B1

## Beschreibung

Die Erfindung betrifft ein Verfahren zur elektrischen Prüfung von Mikroverdrahtungen nach dem Oberbegriff des Patentanspruchs 1.

Für die elektrische Prüfung von Leiterplatten werden üblicherweise mechanische Nadeladapter verwendet, die bei einem Prüfraster, dessen Rasterabmessungen weniger als 200 µm beträgt, an ihre technologische Grenze stoßen. Für die Prüfung von miniaturisierten Leiterplatten und Mikroverdrahtungen wird deshalb nach neuen Prüfmethoden gesucht.

Aus der deutschen Offenlegungschrift DE—A—2 215 179 ist ein Verfahren zur berührungslosen Messung von elektrischen Widerständen bekannt. Hierbei wird ein erstes Ende des zu messenden Widerstandes mit Hilfe einer ersten Elektronensonde auf ein erstes Potential aufgeladen. Der Sekundärelektronen- Emissionskoeffizient am Auftreffort de ersten Elektronensonde muß hierbei kleiner als I sein. Das andere Ende des Widerstandes wird mit einer zweiten Elektronensonde derart bestrahlt, daß der Sekundär-Emissionskoeffizient größer als I ist. Im stationären Zustand weisen sowohl der Auftreffort der ersten als auch der Auftreffort der zweiten Elektronensonde jeweils ein bestimmtes Potential auf, wobei zwischen diesen Punkten ein Strom einer bestimmten Stärke fließt. Außerdem wird vom Auftreffort der zweiten Elektronensonde ein Sekundärelektronenstrom mit einer bestimmten Stärke emittiert. Bei dem bekannten Verfahren wird der Widerstandswert durch Messung der Potentiale der Auftrefforte der Elektronensonden und der Stärke des Sekundärelektronenstromes ermittelt.

Verfahren zum berührungslosen elektrischen Testen von Leitungsnetzwerken werden in den US—A—4 415 851 und US—A—4 417 203 und der EP—A—0 104 577 beschrieben.

Bei diesen Verfahren werden Leitbahn-Netzwerke mit wenigstens einer Elektronensonde elektrisch aufgeladen. Besteht zwischen einem aufzulanden Schaltungsknoten und anderen Teilen des Netzwerks eine leitende Verbindung, so wird auch deren Potential geändert. Das Potential der Netzwerkpunkte kann dann durch Nachweis von Sekundärelektronen gemessen werden, deren Energie vom jeweiligen Prüfpunktpotential abhängt. Mit einer solchen Methode lassen sich leitende Verbindungen von unterbrochenen Verbindungen unterscheiden. Ein Maß für das Potential an einem Meßpunkt ist die Größe des Sekundärelektronensignals, das an diesem Meßpunkt abgetastet werden kann. Das Messen des Potentials an einem Meßpunkt über das zu diesem Meßpunkt gehörige Sekundärelektronensignal ist beispielsweise in der US—A—4 277 679 beschrieben. Das Sekundärelektronensignal hängt nicht nur vom Potential des Meßpunktes ab, sondern zusätzlich auch noch in unerwünschter Weise von Nahfeldern in der Umgebung des Meßpunktes, von der Kontamination in der Umgebung des Meßpunktes und von den jeweiligen Elektronenbahnen, die zum Detektor führen und die im allgemeinen für unterschiedliche Engergien der Sekundärelektronen auch unterschiedlich verlaufen.

Werden zum Einschreiben eines Potentials an einem Schaltungsknoten und zum Lesen des Potentials an einem anderen Schaltungsknoten unterschiedliche Energien der Primärelektronen benötigt, so ist das Umschalten des Strahlerzeugers auf verschiedene Energien der Primärelektronen nur mit großem technologischen Aufwand möglich. Schließlich haben die Leitbahn-Netzwerke unterschiedliche Kapazitäten und benötigen damit unterschiedliche Zeiten, bis bestimmte Schaltungsknoten auf jeweils eine bestimmte Spannung aufgeladen sind. Bei den genannten Meßverfahren muß daher bei der Messung eines einzelnen Widerstandswertes entweder für den Aufladungsvorgang eine relativ lange Zeite vorgesehen werden, damit man sicher sein kann, daß die Meßanordnung sich im stationären Zustand befindet, oder es muß eine aufwendige Aparatur vorgesehen werden, damit mit einem der genannten Meßverfahren auch der Aufladevorgang messend verfolgt werden kann.

Der vorliegenden Erfindung liegt die Aufgabe zugrunde, ein Verfahren der eingangs genannten Art anzugeben, das es mit relativ einfachen Mitteln ermöglicht, di Auflandung an Mikroverdrahtungen messend zu verfolgen, das es ermöglicht, ein Umschalten eines Strahlerzeugers auf verschiedene Primärenergien zu vermeiden, und bei dem sämtliche mit einem Sekundärelektronensignal verknüpften Nachteile ausgeschaltet sind.

Diese Aufgabe wird erfindungsgemäß durch ein Verfahren nach dem Anspruch 1 gelöst. Ausgestaltungen und Vorteile der Erfindung sind in den Unteransprüchen, der Beschreibung und der Zeichnung dargestellt.

Das der Erfindung zugrunde liegende Prinzip beruht darauf, daß zum Einschreiben einer Potentialinformation in einen Schaltungsknoten und zum Lesen einer Potentialinformation aus einem Schaltungsknoten jeweils getrennte Elektronensonden verwendet werden und daß eine Messung des Potentials an einem Schaltungsknoten über die Ablenkung eines Elektronenstrahls durch die elektrischen Felder in der Umgebung des Schaltungsknotens (Meßpunkt) erfolgt. Durch Anlegen bekannter Spannungen an den Schaltungsknoten und durch Messung des jeweils resulteirenden Ablenkwinkels, mit dem der Elektronenstrahl an dem zu prüfenden Schaltungsknoten abgelenkt wird, läßt sich eine Vorrichtung nach der Erfindung eichen.

Obwohl die Erfindung im folgenden in Ausführungsbeispielen für Elektronensonden näher erlaütert wird, ist die Erfindung nicht auf die Verwendung von Elektronensonden beschränkt. Wichtig ist nur, daß ein erster Schaltungsknoten mit einer ersten Korpuskularsonde aufgeladen wird, daß von diesem ersten Schaltungsknoten über eine evtl. leitende Verbindung Ladung zu einem zeiten Schaltungsknoten transportiert werden soll bzw. worden sein soll, daß infolge dessen dieser zweite Schaltungsknoten elektrisch positiv oder negativ aufgeladen wird bzw. aufgeladen worden ist oder bei defekter elektrischer Leitung in seinem Potential nicht verändert worden ist, und daß als Lesestrahl eine zweite Korpuskularsonde verwendet wird, bei der die Ladung der Korpuskeln dasselbe Vorzeichen aufweist wie die Ladung, mit der der zweite Schaltungsknoten versehen wird bzw. versehen worden ist bzw. versehen werden sollte. Wenn also der zweite Schaltungsknoten negativ aufgeladen wird bzw. aufgelanden worden ist, so wird als Lesestrahl eine Korpuskularsonde mit negativ geladenen Korpuskeln, beispielsweise eine Elektronenstrahlsonde, verwendet.

Mit einem Schreibstrahl kann ein erster Schaltungsknoten für sich allein in definierter Weise aufgeladen werden. In einem solchen Fall wird man einen Raster-Korpuskularstrahl verwenden. Mit einem Schreibstrahl kann jedoch ebenso eine Gruppe von ersten Schaltungsknoten in definierter Weise elektrisch aufgeladen werden. Für einen solchen Zweck kann entweder wiederum ein Raster-Korpuskularstrahl Verwendung finden; ebenso kann jedoch auch ein Flachstrahl eingesetzt werden. Zur Prüfung von komplex aufgebauten elektrischen Verbindungen zwischen verschiedenen Meßpunkten kann auch eine beliebige Anzahl von Schreibstrahlen verwendet werden, die wiederum aus einer beliebigen Kombination von Raster-Korpuskularstrahlen und Flachstrahlen zusammengesetzt sein können.

Die für das Einschreiben von Potentialinformationen in Meßpunkte angegebenen Möglichkeiten können sinngemäß auch zum Auslesen von Potentialinformationen aus Schaltungsknoten verwendet werden. Auch zum Auslesen von Potentialinformationen aus den in den Patentansprüchen sogenannten "zweiten Schaltungsknoten" kann eine beliebige Kombination von Raster-Korpuskularstrahlen und Flachstrahlen verwendet werden. Da ein Raster-Korpuskularstrahl besonders einfach und rasch in einer Dimension geführt werden kann, können verteilhafterweise zur Auslesen von Potentialinformation aus Schaltungsknoten, die in einer zweidimensionalen Fläche angeordnet sind, zwei zueinander senkrecht angeordnete Korpuskularsonden eingesetzt werden. Diese beiden Lesesonden werden parallel zu der zweidimensionalen Fläche geführt, in der die zu überprüfenden Schaltungsknoten angeordnet sind. Dabei weisen diese beiden Lesesonden einen Abstand zu der Fläche, in der diese Schaltungsknoten angeordnet sind, auf. Dieser Abstand ist so gewählt, daß die Lesesonden beim Auslesen von Potentialinformation aus den Schaltungsknoten diese Schaltungsknoten nicht berühren, damit von den Lesesonden an den Schaltungsknoten keine Sekundärelektronen ausgelöst werden können. Andererseits soll der Abstand zwischen der Fläche, in der die Schaltungsknoten angeordnet sind, und den Lesesonden, die parallel zu dieser Oberfläche verlaufen, so klein ein, daß die Stärke der Wechselwirkung zwischen den Lesesonden und dem Potential eines Schaltungsknotens groß genug ist für ein gutes Meßergebnis. Diese Angaben über den Abstand einer Lesesonde zu einem zu überprüfenden Schaltungsknoten gilt generell, unabhängig von Art und Anzahl der Lesesonden.

Werden zwei Lesesonden parallel zu einer Fläche, in der die zu überprüfenden Schaltungsknoten angeordnet sind, und senkrecht zueinander geführt, so kann eine der beiden Lesesonden eine x-Koordinate der zu überprüfenden Schaltungsknoten und die zweite der beiden Lesesonden eine y-Koordinate dieser Schaltungsknoten definieren. In dieser Weise kann in einfacher Weise jeder Schaltungsknoten in einer zweidimensionalen Fläche mit zwei Lesesonden angesteuert werden. Überquert eine Lesesonde nur einen einzigen Schaltungsknoten, der in einer zu überprüfenden Weise aufgeladen wird bzw. aufgeladen worden ist, so kann das Potential dieses einzigen Schaltungsknotens quantitativ auch bereits mit Hilfe einer einzigen Lesesonde ermittelt werden. Überquert eine Lesesonde mehrere Schaltungsknoten, die aufgeladen werden bzw. aufgeladen worden sind und deren Potentiale ermittelt werden sollen, so ist es sinnvoll, mit zwei zueinander senkrecht angeordneten Lesesonden jeden einzelnen dieser Schaltungsknoten so anzusteuern, daß jeder einzelne dieser Schaltungsknoten bei jeweils einer einzelnen Messung in Schnittpunkt dieser beiden Lesesonden angeordnet ist. Durch Vergleich mit den Meßergebnissen, die mit einem fehlerfreien Prüfling (golden device) erzielt worden sind, kann sodann ermittelt werden, ob das Potential an einem Schaltungsknoten einem fehlerfreien Verhalten eines Prüflings entspricht oder nicht.

Liegen mehrere Schaltungsknoten, die aufgeladen werden bzw. aufgeladen worden sind und deren Potentiale überprüft werden sollen, dicht benachbart nebeneinander, so kann durch Variation der Primärenergien der Lesesonden und durch Vergleich mit den Meßergebnissen, die von einem fehlerfreien Prüfling gewonnen worden sind, zusätzliche Information über das Verhalten eines Systems von leitenden Verbindungen zwischen verschiedenen Schaltungsknoten erhalten werden. Je kleiner die Primärstrahlenergien eines Lesestrahles sind, desto stärker werden die Korpuskeln eines solchen Lesestrahles in der Nähe einer gleichnamigen Ladung abgelenkt. Bei einer kleinen Primärstrahlenergie einer Lesesonde spüren die Korpuskeln daher nur das Potential eines einzigen aufgeladenen Schaltungsknotens, während bei hohen Primärstrahlenergien einer Lesesonde die Korpuskeln soviel Energie mitbringen können, daß sie trotz Ablenkung an mehreren aufgeladenen Schaltungsknoten über den Auftreffort auf einem ortsempfindlichen Detektor noch Information darüber mitbringen können, ob sie an einem Schaltungsknoten mehr oder weniger abgelenkt worden sind. Durch Kombination der Meßergebnisse von zwei oder mehreren Lesesonden, die in beliebigen Kombinationen sich jeweils über einem Schaltungsknoten kreuzen und die nicht notwendig senkrecht zueinander angeordnet sein müssen, kann so das Potential eines Schaltungsknotens ermittelt werden.

Ein Ausführungsbeispiel der Erfindung ist in der Zeichnung dargestellt und wird im folgenden näher erläutert.

Fig. 1 zeigt eine Vorrichtung zur elektrischen Prüfung von Mikroverdrahtungen mit getrennten Schreibsonden und Lesesonden nach der Erfindung.

Fig. 2 erläutert die Aufladung eines Schaltungsknotens.

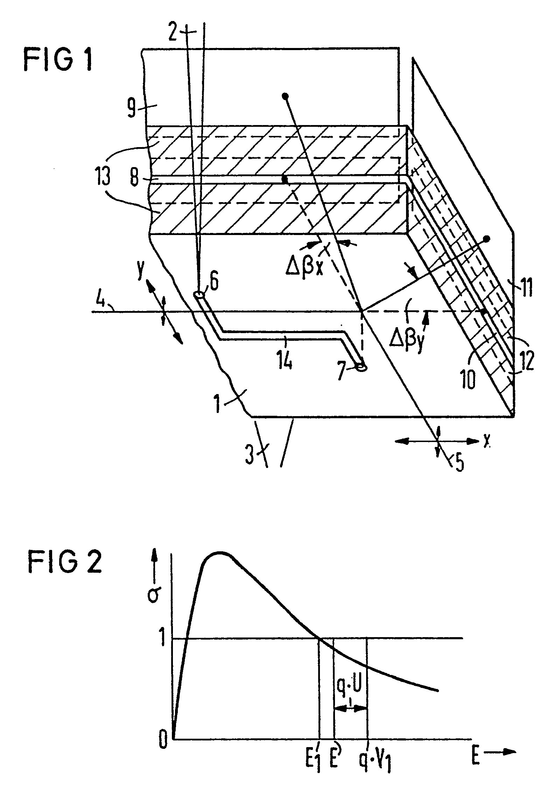

Fig. 1 zeigt eine Vorrichtung zur elektrischen Überprüfung einer Mikroverdrahtung 1. Ein Schaltungsknoten 6 innerhalb der Mikroverdrahtung 1 wird mit Hilfe eines Raster-Elektronenstrahles 2, der als Schreibsonde fungiert, auf ein bestimmtes Potential aufgeladen. Das elektrische Aufladen des Schaltungsknotens 6 mit Hilfe einer Schreibsonde 2 kann in einer Weise erfolgen, wie sie in den beiden obengenannten US-Patentschriften beschrieben ist. Wenn die elektrische Verbindung 14 zwischen dem ersten Schaltungsknoten 6 und einem zweiten Schaltungsknoten 7 elektrisch leitend ist, wird bereits während aus Aufladevorganges am Schaltungsknoten 6 Ladung vom Schaltungsknoten 6 über die elektrische Verbindung 14 zum Schaltungsknoten 7 transportiert. Der Vorteil der Erfindung gegenüber dem Stand der Technik besteht nun darin, daß am zweiten Schaltungsknoten 7 nicht mit Hilfe einer zweiten Elektronensonde ein Sekundärelektronenstrom erzeugt werden muß. Das Erzeugen eines Sekundärelektronensstromes bringt nämlich zusätzliche Meßunsicherheiten ins Spiel. Bei einer Vorrichtung nach dem Ausführungsbeispiel von Fig. 1 werden zwei Lesesonden 4, 5 parallel zur Oberfläche der Mikroverdrahtung 1 und in einem Abstand von dieser Oberfläche der Mikroverdrahtung 1 senkrecht zueinander so geführt, daß die beide oberhalb des zweiten Schaltungsknotens 7 verlaufen. Die beiden Lesesonden 4, 5 sollen sich natürlich nicht unmittelbar gleichzeitig oberhalb des zweiten Schaltungsknotens 7 kreuzen, weil sie sich sonst aufgrund ihrer geladenen Korpuskel gegenseitig zusätzlich in unkontrollierbarer Weise beeinflussen würden. Die Lesesonden 4, 5 können daher zeitlich hintereinander im selben Abstand oberhalb des zweiten Schaltungsknotens 7 geführt werden oder können auch jeweils verschiedene Abstände zur Oberfläche der Mikroverdrahtung 1 aufweisen. Ist der Schaltungsknoten 7 nicht aufgeladen, so wird die Lesesonde 5 oberhalb des Schaltungsknotens 7 nicht abgelenkt und kann in einem Detektor 8 nachgewiesen werden. Ist der Schaltungsknoten 7 aufgeladen, so wird die Lesesonde 5 oberhalb des Schaltungsknotens 7 durch elektrische Abstoßung abgelenkt und kann in einem Detektor 9 nachgewiesen werden. Um die Nachweissicherheit zu erhöhen, können die Detektoren 8 und 9 voneinander durch Schirme 13 getrennt werden.

Wenn der Schaltungsknoten 7 nicht aufgeladen ist, wird die Lesesonde 4 nicht abelenkt und kann in einem Detektor 10 nachgewiesen werden. Wenn der Schaltungsknoten 7 aufgeladen ist, wird die Lesesonde 4 oberhalb des Schaltungsknotens 7 durch elektrische Abstoßung abgelenkt und kann in einem Detektor 11 nachgewiesen werden. Zur Nachweissicherheit können die beiden Detektoren 10, 11 wiederum durch einen Schirm 12 getrennt werden.

Die Lesesonde 5 kann in x-Richtung parallel zur Oberfläche der Mikroverdrahtung 1 hin und her geschoben werden. Die Lesesonde 4 kann in y-Richtung ebenfalls parallel zur Oberfläche der Mikroverdrahtung 1 hin und her geschoben werden. Der geometrische Kreuzungspunkt der Lesesonden 4 und 5 definiert auf diese Weise jeweils die Koordinaten $x_i$, $y_j$ eines zu überprüfenden Schaltungsknotens 7. Die Lesesonden 4, 5 können auch in einer Richtung senkrecht zur Oberfläche der Mikroverdrahtung 1 verschoben werden. Dadurch kann beispielsweise erreicht werden, daß wenigstens eine der beiden Lesesonden 4, 5 direkt auf den Schaltungsknoten 7 trifft und bei geeigneter Primärstrahlenergie eine Sekundärstrahl-Emission am Schaltungsknoten 7 auslösen kann und dadurch eine auf dem Schaltungsknoten 7 vorhandene Ladung löschen kann.

In der Fig. 1 sind als Lesesonden 4 und 5 sogenannte linienförmige Fadenstrahlen eingezeichnet. Ebenso können jedoch auch Flachstrahlen verwendet werden. Beispielsweise kann anstelle der Lesesonde 5 ein solcher Flachstrahl verwendet werden. Ein solcher Flachstrahl kann gleichzeitig die gesamte Oberfläche der Mikroverdrahtung 1 oder einen Teil davon in einem bestimmten Abstand zu dieser Mikroverdrahtung 1 überstreichen. Wenn die Detektoren 8 und 9 in der in Fig. 1 eingezeichneten x-Richtung ortsempfindlich sind, kann nachgewiesen werden, bei welcher x-Koordinate wenigstens ein Schaltungsknoten aufgeladen ist.

Auch zum Einschreiben von Potentialinformation in erste Schaltungsknoten 6, die sich beispielsweise auf der Unterseite der Mikroverdrahtung 1 befinden, kann ein Flachstrahl 3 verwendet werden. Ein solcher Flachstrahl 3 ist beispielsweise in den oben angegebenen US-Patentschriften näher beschrieben.

Die primärstrahlenergien der Lesesonden 4 und 5 müssen nicht notwendig gleich groß sein. Wenn die Primärstrahlenergien der Lesesonden 4 und 5 verschieden sind, dann sind auch die Ablenkwinkel $\Delta\beta_x$ und $\Delta\beta_y$ voneinander verschieden. Wenn beispielsweise der Detektor 9 auch noch in derjenigen Richtung, die senkrecht auf der Oberfläche der Mikroverdrahtung 1 steht, ortsempfindlich ist, kann unterschieden werden, ob die Lesesonde 5 oder an mehreren Schaltungsknoten aufgrund von elektrischer Abstoßung abgelenkt worden ist.

Die Lesesonden 4 und 5 müssen nicht notwendig parallel zur Oberfläche der Mikroverdrahtung 1 geführt werden. Wichtig ist, daß die Lesesonden 4 und 5 beim Auslesen von Potentialinformation keine Sekundärelektronen auslösen und daß anderseits ihre Wechselwirkung mit den elektrischen Feldern auf der Oberfläche der Mikroverdrahtung 1 groß genug ist, um eine Aussage über die Größe eines Potentials treffen zu können.

Fig. 2 erläutert den Vorgang der Aufladung eines zweiten Schaltungsknotens 7 über das Aufladen eines ersten Schaltungsknotens 6. Um die Aufladung eines ersten Schaltungsknotens 6 mit Hilfe einer Schreibsonde 2 erläutern zu können, müssen einige Angaben über Sekundärelektronen-Emission fester

4

**EP 0 166 912 B1**

Körper bei Bestrahlung mit geladenen Teilchen gemacht werden. Der physikalische Effekt der Sekundärelektronen-Emission ist dem Fachmann auf dem Gebiet der Elektronenstrahl-Meßtechnik wohlbekannt. Einzelheiten über die Sekudärelektronen-Emission sind beispielsweise in der obengenannten US-Patentschrift US—A—4 415 851 angegeben. Weitergehende Information über die "Sekundärelektronen-Emission fester Körper bei Bestrahlung mit Elektronen" findet man in einer Veröffentlichung von R. Kollath in "Handbuch der Physik" (Herausgeber S. Flügge), Bd. 21, 1956, Seiten 232—303.

Bei Bestrahlung eines ersten Schaltungsknotens 6 mit Hilfe einer Schreibsonde 2 werden von diesem Schaltungsknoten 6 sowohl Rückstreuelektronen als auch Sekundärelektronen emittiert. Bei niedrigen Primärstrahlenergien der Schreibsonde 2 kann man bei den aus dem Bereich des Schaltungsknotens 6 austretenden Elektronen nicht zwischen Sekundärelektronen und Rückstreuelektronen unterscheiden. Für Primärstrahlenergien im Bereicht von etwa 1 keV bis etwa 5 keV (bei senkrechtem Einfall des Primärstrahles) werden daher alle aus dem Bereich des Schaltungsknotens 6 austretenden Elektronen als Sekündärelektronen gezählt. Unter der Elektronausbeute versteht man die pro Primärstrahlektron im Bereich des Schaltungsknotens 6 freigesetzte Zahl der Sekundärelektronen und Rückstreuelektronen.

Fig. 2 zeigt die Elektronenausbeute $\sigma$ als Funktion der Energie E. Mit der "Lande"-Energie E landen die Primärelektronen des Schreibstrahles 2 auf der Oberfläche des Schaltungsknotens 6 dann, wenn die Spannung des Strahlerzeugers des Schreibstrahles 2 den Wert $V_1$ beträgt und wenn diese Primärelektronen am Schaltungsknoten 6 durch eine Gegenspannung U abgebremst werden. Wenn der Schaltungsknoten 6 elektrisch isoliert wäre, müßte die "Lande"-Energie E der Primärelektronen den Wert $E_1$ aufweisen, damit die Elektronenausbeute $\sigma$ den Wert 1 besitzen würde. Wenn die Elektronenausbeute $\sigma$ Wert 1 aufweist, verlassen genauso viele Elektronen den Schaltungsknoten 6 als Rückstreuelektronen oder als Sekundärelektronen wie Primärelektronen auf diesen Schaltungsknoten 6 auftreffen. Wenn die Elektronenausbeute $\sigma$ den Wert 1 aufweist, wird das Potential des Schaltungsknotens 6 über die Schreibsonde 2 nicht verändert. Damit der Schaltungsknoten 6 negativ aufgelanden werden kann, muß die Elektronenausbeute $\sigma$ kleiner als 1 sein. Dann bleiben mehr Primärelektronen im Schalungsknoten 6 stecken, als Sekundärelektronen und Rückstreuelektronen aus diesem Schaltungsknoten 6 austreten.

Wenn der Schaltungsknoten 6 elektrisch leitend mit einem zweiten Schaltungsknoten 7 verbunden ist, und wenn der elektrischen Verbindung 14 zwischen den beiden Schaltungsknoten 6 und 7 ein Widerstandswert R und eine Kapazität C zugeordnet werden kann, kann elektrische Ladung vom Schaltungsknoten 7 abfließen, und zwar solange, bis sich ein Gleichgewichtszustand zwischen dem Aufladen des Schaltungsknotens 6 über die Schreibsonde 2 und dem Transport von Ladung über die elektrische Verbindung 14 zum Schaltungsknoten 7 eingestellt hat. Um ein stabiles Gleichgewicht zur erhalten, muß die "Lande"-Energie E der Primärelektronen (im beschriebenen Beispiel, wo der Schaltungsknoten 6 negativ aufgeladen werden soll) größer als $E_1$ sein. Auf dem Weg ins Gleichgewicht weist die "Lande"-Energie E am Schaltungsknoten 6 einen Wert auf, der größer ist als die Elektronenergie $E_1$ und kleiner als die Spannung $V_1$ des Primärstrahlerzeugers der Schreibsonde 2, multipliziert mit der Elementarladung q. Da im allgemeinen vor Durchführung einer Messung sämtliche Schaltungsknoten einer Mikroverdrahtung 1 auf Erdpotential gelegt werden, und da im allgemeinen ein zweiter Schaltungsknoten 7 über einen weiteren Widerstand mit einem festen Potential verbunden ist, das beispielsweise durch einen Schreibstrahl 3 erzeugt werden kann, wird auch im Gleichgewichtszustand die "Lande"-Energie E am Schaltungsknoten 6 einen Wert größer als die Elektroenenergie $E_1$ und kleiner als die Spannung $V_1$ des Strahlerzeugers der Schreibsonde 2, multipliziert mit der Elementlandung $\sigma$, aufweisen. Wenn das Gebilde, das aus den beiden Schaltungsknoten 6 und 7 und das aus der elektrischen Verbindung 14 besteht, elektrisch isoliert ist, wird im allgemeinen die "Lande"-Energie E am Schaltungsknoten 6 im Gleichgewichtszustand gleich der Elektronenergie $E_1$ sein.

Wenn auf dem Weg in den Gleichgewichtszustand die Spannung am Schaltungsknoten 7 mehrmals hintereinander gemessen wird, können die Messungen quantitativ ausgewertet werden. Dabei gilt näherungsweise folgende Gleichung:

$$ C \cdot \left[ 1 + R\, i_p \propto q \right] = \frac{\pi}{2 \ln \frac{2L}{d}} \frac{(V_1 - {}^{E_1}/_q)}{V_2} (i_p \propto q) \frac{\Delta t}{\Delta \beta} $$

Mit:

C: Kapazität, die der Leitbahn 14 zugeordnet werden kann,

R: Widerstandswert, der der Leitbahn 14 zugeordnet werden kann,

$i_p$: Primärelektronenstrom der Schreibsonde 2,

$\sigma$: Wert der mathematischen Ableitung der Elektronenausbeute als Funktion der "Lande"-Energie E, wenn man die Funktion der Elektronenausbeute $\sigma$ nach der "Lande"-Energie E differenziert und wenn man für die "Lande"-Energie E nach der Differentiation den Wert $E_1$ einsetzt,

$\Delta\beta$: Ablenkwinkel der Lesesonde 4 bzw. der Lesesonde 5,

$\Delta t$: zum Ablenkwinkel $\Delta\beta$ zugehörige Meßzeit,

q: Elementarladung

d: Durchmesser der Leitbahn 14,

L: Länge der Leitbahn 14,

$V_1$: Spannung des Strahlerzeugers der Schreibsonde 2,

$V_2$: Spannung des Strahlerzeugers einer Lesesonde 4, 5.

5

In Abhängigkeit von der jeweiligen Meßzeit $\Delta t$ erhält man für jede Lesesonde jeweils einen Ablenkwinkel $\Delta\beta$. Auf diese Weise kann man beispielsweise zwei Gleichungen für die beiden Unbekannten R, C bekommen. Danach lassen sich beispielsweise für Zinn oder für Kupfer Widerstandswerte R im Bereich von $10^9$ bis $10^{13}$ Ohm und Kapazitäten C im Bereich von $10^{-9}$ bis $10^{-17}$ Farad unterscheiden.

Die oben angegebene Gleichung zur Bestimmung von R, C gilt näherungsweise. Die besten Meßergebnisse erhält man, wenn die Spannung $V_1$ des Strahlerzeugers einer Schreibsonde 2, 3 nur ein wenig größer ist als diejenige Spannung, die dem Quotienten $E_1/q$ entspricht.

Nach durchgeführter Messung kann mit Hilfe einer Lesesonde 4, 5 das Potential, am Schaltungsknoten 7 gelöscht werden. Zu diesem Zweck wird die Lesesonde 4, 5 direkt auf den Schaltungsknoten 7 gerichtet. Die Energie der Lesesonde 4, 5 wird dabei so gewählt, daß die Elektronenausbeute $\sigma$ am Schaltungsknoten 7 in diesem Fall größer als 1 ist.

Die Spannung $V_2$ des Strahlerzeugers einer Lesesonde 4, 5 soll im Ausführungsbeispiel geringfügig kleiner sein als der Quotient $E_1/q$. Der Wert $E_1$ leigt bei Senkrechteinfall einer Schreibsonde 2, 3 in der Größenordnung 3—4 keV und wird bei Schrägeinfall einer Sonde 2, 3, 4, 5 zu höheren Werten hin verschoben, weil bei Schrägeinfall die Elektronenausbeute ansteigt.

Bei geeigneter Spannung $V_1$ können die Schaltungsknoten 6, 7 auch positiv aufgeladen werden. Eine Lesesonde müßte dann aus positiv geladenen Teilchen (Ionen) bestehen.

Als Detektoren 8, 9, 10, 11 können Halbleiter-Arrays verwendet werden, wie sie aus der Meßtechnik wohlbekannt sind. Als Detektoren 8, 9, 10, 11 können auch Faserbündel verwendet werden, die mit einem Lichtleitstab gekoppelt werden. Eine Fernsehkamera kann schließlich optisch mit diesem Lichtleitstab gekoppelt werden. Ein solches System, bestehend aus Faserbündel, Lichtleitstab und Fernsehkamera, bildet genau so einen ortsempfindlichen Detektor wie beispielsweise ein oben bereits erwähnter Halbleiter-Array-Detektor. Auf welche Licht-leitfaser eine Lesesonde, 4, 5 aufgetroffen ist, kann mit der Fernsehkamera über Detektion eines hellen Punktes als Funktion des Ortes festgestellt werden. Wichtig ist, daß eine Lesesonde 4, 5 beim Auftreffen auf einen Detektor 8, 9, 10, 11 dabei genügend Signalintensität auslöst. Litchleiter können daher an demjenigen Ende, an dem die zu detektierende Strahlung auftreffen soll, eine Einrichtung zur Verstärkung der Lichtintensität aufweisen, wie z.B. einen Film aus Material mit starker Lumineszenz, beispielsweise einem Plastikszintillator. Zusätzlich kann zwischen Litchleitstab und Fernsehkamera auch noch eine Einrichtung zur Signalverstärkung angeordnet werden. Eine weitere Möglichkeit zur Ausbildung von Detektoren 8, 9, 10, 11 ist die Verwendung von Lumineszenzdioden, von denen eine oder mehrere Dioden für einen jeden Detektor angeordnet werden kann.

## Patentansprüche

1. Verfahren zur elektrischen Prüfung von Mikroverdrahtungen (1), bei dem ein erster Schaltungsknoten (6) mit einer ersten Korpuskularsonde (2, 3) aufgeladen wirde und bei dem wenigstens ein zweiter Schaltungsknoten unter Verwendung einer zweiten Korpuskularsonde (4) daraufhin überprüft wird, ob dieser mit dem ersten Schaltungsknoten (6) leitend verbunden ist, dadurch gekennzeichnet, daß die zweite Korpuskularsonde (4) im Bereich der von dem zweiten Schaltungsknoten (7) ausgehenden elektrischen Felder abgelenkt wird und daß das Potential des zweiten Schaltungsknotens (7) aus der sich ergebenden Ablenkung ($\Delta\beta_x$, $\Delta\beta_y$) der zweiten Korpuskularsonde (4) qualitative oder quantitativ bestimmt wird.

2. Verfahren nach Ansruch 1, dadurch gekennzeichnet, daß der zweite Schaltungsknoten (7) zur Eichung der Ablenkung ($\Delta\beta_x$, $\Delta\beta_y$) der zweiten Korpuskularsonde (4) auf bekannte Potentiale gelegt wird.

3. Verfahren nach Anspurch 1 oder 2, dadurch gekennzeichnet, daß die Ablenkung ($\Delta\beta_x$, $\Delta\beta_y$) der zweiten Korpuskularsonde (4) während der Aufladung des ersten Schaltungsknotens (6) mindestens zweimal gemessen wird und daß hieraus die Größe des Widerstands (R) und der Kapazität (C) des den ersten und den zweiten Schaltungsknoten (6, 7) verbindenden Netzwerks (14) ermittelt wird.

4. Verfahren nach einem der Ansprüche 1 bis 3, dadurch gekennzeichnet, daß eine dritte Korpuskularsonde (5) im Bereich der von dem zweiten Schaltungsknoten (7) ausgehenden elektrischen Feldern abgelenkt wird und daß die Strahlrichtung der dritten Korpuskularsonde (4) annähernd senkrecht zur Strahlrichtung der zweiten Korpuskularsonde (4) orienteirt ist.

5. Verfahren nach einem der Ansprüche 1 bis 4, dadurch gekennzeichnet, daß der zweite Schaltungsknoten (7) nach Durchführung einer Messung durch Bestrahlung mit der zweiten oder dritten Korpuskularsonde (4, 5) entladen wird.

6. Verfahren nach einem der Ansprüche 1 bis 5, dadurch gekennzeichnet, daß wenigstens eine der Korpuskularsonden (2, 4, 5) als Fadenstrahl ausgebildet wird.

7. Verfahren nach einem der Ansprüche 1 bis 6, dadurch gekennzeichnet, daß wenigstens eine der Korpuskularsonden (2, 3, 4, 5) als Falchstrahl ausgebildet ist.

8. Verfahren nach einem der Ansprüche 1 bis 7, dadurch gekennzeichnet, daß wenigstens ein ortsempfindlicher Detektor (8, 9, 10, 11) zum Nachweis einer Korpuskularsonde (4, 5) verwendet wird.

## Revendications

1. Procédé pour contrôler électriquement des microcâblages (1), selon lequel on charge un premier noeud (6) d'un circuit à l'aide d'une première sonde corpusculaire (2, 3) et un contrôle au moins un second noeud du circuit en utilisant une seconde sonde corpusculaire (4) pour déterminer si ce noeud est relié de façon conductrice au premier noeud (6) du circuit, caractérisé en ce qu'on dévie la seconde sonde corpusculaire (4) dans la zone du champ électrique émanant du second noeud (7) du circuit et qu'on détermine d'un manière qualitative ou quantitative le potential du second noeud (7) du circuit à partir de la déviation obteneu ($\Delta\beta_x$, $\Delta\beta_y$) de la seconde sonde corpusculaire (4).

2. Procédé selon la revendication 1, caractérisé par la fait qu'on applique des potentials connus au second noeud (7) (du) circuit pour étalonner la déviation ($\Delta\beta_x$, $\Delta\beta_y$) de la seconde sonde corpusculaire (4).

3. Procédé selon la revendication 1 ou 2, caractérisé par la fait qu'on mesure qu'on mesure au moins deux fois la déviation ($\Delta\beta_x$, $\Delta\beta_y$) de la seconde sonde corpusculaire (4) pendant l'application d'une charge au premier neoud (6) du circuit et qu'on déterminé, à partir de là, la valeur de la résistance (R) et de la capacité (C) du réseau (14) reliant les premier et second noeuds (6, 7) du circuit.

4. Procédé suivant l'une des revendications 1 à 3, caractérisé par la fait qu'on dévie un troisième sonde corpusculaire (5) dans la zone des champs électriques émanant du second noeud (7) du circuit et qu'on oriente la direction du faisceau de la troisième sonde corpusculaire (4) approximativement perpendiculairement à la direction du faisceau de la seconde sonde corpusculaire (4).

5. Procédé selon l'une des revendications 1 à 4, caractérisé par la fait qu'après l'exécution d'une mesure, on décharge le second noeud (7) du circuit par irradiation à l'aide de la seconde ou de la troisième sonde corpusculaire (4, 5).

6. Procédé selon l'une des revendications 1 à 5, caractérisé par la fait qu'au moins l'une des sondes corpusculaires (2, 4, 5) est réalisée sous la forme d'un faisceau étroit.

7. Procédé selon l'une des revendications 1 à 6, caractérisé par la fait qu'au moins l'une des sondes corpusculaires (2, 4, 5) est réalisée sous la forme d'un faisceau plat.

8. Procédé suivant l'une des revendications 1 à 7, caractérisé par la fait qu'on utilise au moins un détecteur (8, 9, 10, 11) sensible à la position, pour détecter une sonde corpusculaire (4, 5).

**Claims**

1. Method of electrically testing microwirings (1), in which a first circuit node (6) is charged with a first particle probe (2, 3) and in which at least one second circuit node is tested using a second particle probe (4) as to whether the latter is conductively connected with the first circuit node (6), characterized in that the second particle probe (4) is deflected in the region of the electrical fields originating from the second circuit node (7) and in that the potential of the second circuit node (7) is determined qualitatively or quantitatively from the resulting deflection ($\Delta\beta_x$, $\Delta\beta_y$) of the second particle probe (4).

2. Method according to Claim 1, characterized in that the second circuit node (7) is placed at known potentials for the calibration of the deflection ($\Delta\beta_x$, $\Delta\beta_y$) of the second particle probe (4).

3. Method according to Claim 1 or 2, characterized in that the deflection ($\Delta\beta_x$, $\Delta\beta_y$) of the second particle probe (4) is measured at least twice during the charging of the first circuit node (6) and in that, from this, the magnitude of the resistance (R) and of the capacitance (C) of the network (14) connecting the first and the second circuit node (6, 7) is determined.

4. Method according to one of Claims 1 to 3, characterized in that a third particle probe (5) is deflected in the region of the electrical fields originating from the second circuit node (7) and in that the direction of radiation of the third particle probe (4) is arranged to be approximately perpendicular to the direction of radiation of the second particle probe (4).

5. Method according to one of Claims 1 to 4, characterized in that the second circuit node (7) is discharged after the execution of a measurement by irradiation with the second or third particle probe (4, 5).

6. Method according to one of Claims 1 to 5, characterized in that at least one of the particle probes (2, 4, 5) is in the form of a gas-concentrated particle beam.

7. Method according to one of Claims 1 to 6, characterized in that at least one of the particle probes (2, 3, 4, 5) is in the form of a flat beam.

8. Method according to one of Claims 1 to 7, characterized in that at least one location-sensitive detector (8, 9, 10, 11) is used for detecting particle probe (4, 5).

FIG 1

FIG 2